# EUROPEAN PATENT APPLICATION

(11) **EP 2 963 996 A1**
(43) Date of publication of application: **06.01.2016**
(21) Application number: 14878451.5
(22) Date of filing: 06.11.2014
(51) Int. Cl.: H05B 33/04, H01L 51/50, H05B 33/10

(54) **ORGANIC ELECTROLUMINESCENT DEVICE AND METHOD FOR MANUFACTURING ORGANIC ELECTROLUMINESCENT DEVICE**

(30) Priority: 14.01.2014 JP 2014004536
(71) Applicant: Nitto Denko Corporation, Ibaraki-shi, Osaka 567-8680 (JP)
(72) Inventor: YAMADA Yasumi, Ibaraki-shi Osaka 567-8680 (JP)
(74) Representative: Grünecker Patent- und Rechtsanwälte PartG mbB
(86) International application number: PCT/JP2014/079481
(87) International publication number: WO 2015/107755

(57) **Abstract**

An organic electroluminescence device 1 includes a support substrate 2, an organic electroluminescence element 3, a moisture absorbing layer 4, a moisture-barrier layer 5 provided on the moisture absorbing layer 4, and a concentration gradient layer 6 provided between the moisture absorbing layer 4 and the moisture-barrier layer 5, wherein the moisture absorbing layer 4 contains a component having moisture absorption, the moisture-barrier layer 5 contains a component having moisture barrier, and the concentration gradient layer 6 contains a component having moisture absorption and a component having moisture barrier, and has a portion in which the content of the component having moisture absorption continuously decreases toward the moisture-barrier layer 5 side from the moisture absorbing layer 4 side.

## Description

### TECHNICAL FIELD

The present invention relates to an organic electroluminescence device and the like.

### BACKGROUND ART

Hereinafter, an organic electroluminescence is referred to as an "organic EL".

Conventionally, an organic EL device including a supporting substrate and an organic EL element provided on the supporting substrate is known. The organic EL element includes a first electrode, a second electrode, and an organic layer provided between the first and second electrodes.

The organic EL element is easily degraded by moisture. For example, Patent Document 1 discloses an organic EL device including an organic EL element provided on a support substrate, a moisture absorbing layer provided on the organic EL element, and a gas barrier layer provided on the moisture absorbing layer for preventing degradation caused by moisture of the organic EL element. The moisture absorbing layer in Patent Document 1 is formed of a metal oxide such as calcium oxide or strontium oxide, and the gas barrier layer is formed of silicon nitride, silicon oxide or silicon nitride oxide. The gas barrier layer corresponds to a moisture-barrier layer.

According to the organic EL device in Patent Document 1, penetration of moisture into the organic EL device can be prevented by the gas barrier layer, and further, the moisture absorbing layer provided between the gas barrier layer and the organic EL element absorbs moisture, so that degradation caused by moisture of the organic EL element can be suppressed.

However, when the moisture absorbing layer absorbs moisture, the moisture absorbing layer is expanded in volume, and therefore the gas barrier layer may be partially peeled off from the moisture absorbing layer, or the gas barrier layer and the moisture absorbing layer may be cracked. When the peeling or cracking occurs, moisture penetrates from the affected part into the organic EL element to degrade the organic EL element. Thus, conventional organic EL devices have a short light emission life, and it is required to improve the light emission life.

[Patent Document 1] JP 2011-020335 A

### SUMMARY OF THE INVENTION

An object of the present invention is to provide an organic EL device, the light emission life of which is increased by preventing peeling between a moisture-barrier layer and a moisture absorbing layer, etc., and a method for producing the organic EL device.

An organic EL device of the present invention includes a support substrate, an organic EL element provided on the support substrate, a moisture absorbing layer provided on the organic EL element, a moisture-barrier layer provided on the moisture absorbing layer, and a concentration gradient layer provided between the moisture absorbing layer and the moisture-barrier layer, wherein the moisture absorbing layer contains a component having moisture absorption, the moisture-barrier layer contains a component having moisture barrier, and the concentration gradient layer contains a component having moisture absorption and a component having moisture barrier, and has a portion in which the content of the component having moisture absorption continuously decreases toward the moisture-barrier layer side from the moisture absorbing layer side.

Preferably, in the above-mentioned portion, the content of the component having moisture barrier continuously increases toward the moisture-barrier layer side from the moisture absorbing layer side.

Preferably, the content of the component having moisture absorption continuously decreases toward the concentration gradient layer from the moisture absorbing layer.

Preferably, the content of the component having moisture barrier continuously decreases toward the concentration gradient layer from the moisture-barrier layer.

According to another aspect of the present invention, a method for producing an organic EL device is provided.

The method for producing an organic EL device includes a moisture absorbing layer forming step of forming a moisture absorbing layer, which contains a component having moisture absorption, on a support substrate provided with an organic EL element, a concentration gradient layer forming step of forming on the moisture absorbing layer a concentration gradient layer which contains a component having moisture absorption and a component having moisture barrier, and a moisture-barrier layer forming step of forming on the concentration gradient layer a moisture-barrier layer containing a component having moisture barrier, wherein in the concentration gradient layer forming step, the long belt-shaped support substrate after formation of the moisture absorbing layer is conveyed in a vapor deposition area where a first vapor deposition source containing a material that constitutes a component having moisture absorption and a second vapor deposition source containing a material that constitutes a component having moisture barrier are provided side by side in this order, and is conveyed in a direction toward the second vapor deposition source from the first vapor deposition source.

Preferably, in the concentration gradient layer forming step, the support substrate is conveyed so as to draw a helical trajectory, and is made to pass through the vapor deposition area and a non-vapor deposition area alternately.

The organic EL device of the present invention can stably emit light over a long period of time as a moisture-barrier layer is hardly peeled off from a moisture absorbing layer.

### BRIEF DESCRIPTION OF THE DRAWINGS

Fig. 1 is a sectional view of an organic EL device of the present invention (sectional view of the organic EL device taken along a thickness direction).
Fig. 2 is a reference graphical view illustrating a first example of change in contents of a moisture absorbing component and a moisture-barrier component in a moisture absorbing layer, a concentration gradient layer, and a moisture-barrier layer.
Fig. 3 is a reference graphical view illustrating a second example of change in contents of the components.
Fig. 4 is a reference graphical view illustrating a third example of change in contents of the components.
Fig. 5 is a front view illustrating an outline of a vapor deposition apparatus according to one embodiment for forming a moisture absorbing layer, a concentration gradient layer, and a moisture-barrier layer.
Fig. 6 is a left side view of the vapor deposition apparatus.
Fig. 7 is a schematic view illustrating an outline of a vapor deposition apparatus according to another embodiment for forming a moisture absorbing layer, a concentration gradient layer, and a moisture-barrier layer.
Fig. 8 is a front view illustrating an outline of a vapor deposition apparatus for forming a moisture absorbing layer, a mixed layer, and a moisture-barrier layer of an organic EL device of the comparative example.

Hereinafter, the present invention will be described with reference to the drawings. It should be noted that dimensions such as a thickness and a length in the drawings are different from actual dimensions.

In this specification, the terms "first" and "second" may be added as prefixes. These prefixes, however, are only added in order to distinguish the terms and do not have specific meaning such as order and relative merits. In this specification, angles and angular relationships (e.g. orthogonal, parallel and the like) include error ranges that are allowable in the technical field of the present invention. For example, the parallel relationship etc. means being within a range of ±10 degrees, preferably ±5 degrees, from a strict angle. In this specification, the expression of "PPP to QQQ" means "PPP or more and QQQ or less".

### [Configuration of Organic EL Device]

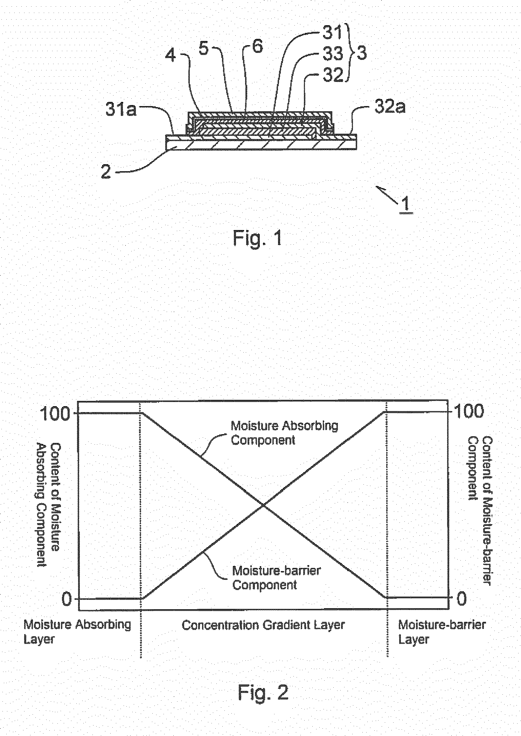

An organic EL device 1 of the present invention includes a support substrate 2, an organic EL element 3 provided on the support substrate 2, a moisture absorbing layer 4 provided on the organic EL element 3, a concentration gradient layer 6 provided on the moisture absorbing layer 4, and a moisture-barrier layer 5 provided on the concentration gradient layer 6 as illustrated in Fig. 1.

The organic EL element 3 includes a first electrode 31 having a terminal 31a, a second electrode 32 having a terminal 32a, and an organic layer 33 provided between the both electrodes 31 and 32.

For example, the terminal 31a of the first electrode 31 is arranged on a first side and the terminal 32a of the second electrode 32 is arranged on a second side with respect to the organic layer 33. The first side and the second side are mutually opposite sides. The moisture absorbing layer 4, the concentration gradient layer 6, and the moisture-barrier layer 5 are stacked and bonded so as to cover a surface of the organic EL element 3 excepting the terminals 31a and 32a.

When the support substrate 2 has electric conductivity, an insulating layer (not illustrated) is provided between the support substrate 2 and the first electrode 31 in order to prevent an electrical short-circuit.

Specifically, the organic EL element 3 is formed into a substantially rectangular shape in a planar view, for example. Of course, a planar shape of the organic EL element 3 is not limited to a substantially rectangular shape, and it may be shaped like a substantially square or circular shape.

The organic layer 33 of the organic EL element 3 includes a light emitting layer, and has various kinds of functional layers such as a positive hole transport layer and an electron transport layer, as necessary. The layer configuration of the organic layer 33 is described later.

For forming the terminal 31a of the first electrode 31, the organic layer 33 is stacked on the surface of the first electrode 31 excepting the end part (terminal 31a) of the first electrode 31 arranged on the first side.

The second electrode 32 is stacked on the surface of the organic layer 33 so as to cover the surface of the organic layer 33. For forming the terminal 32a of the second electrode 32, the end part (terminal 32a) of the second electrode 32 is drawn from the end part of the organic layer 33 to the second side.

The terminals 31a and 32a of the first electrode 31 and the second electrode 32 are portions that are connected to the outside. The terminal 31a of the first electrode 31 is an exposed surface of the first electrode 31, and the terminal 32a of the second electrode 32 is an exposed surface of the second electrode 32.

The moisture absorbing layer 4 is a layer that absorbs moisture. By providing the moisture absorbing layer 4, a slight amount of moisture passing through the moisture-barrier layer 5 is absorbed into the moisture absorbing layer 4, and therefore degradation caused by moisture of the organic EL element 3 can be effectively suppressed. The moisture absorbing layer 4 is stacked on the second electrode 32. In other words, the moisture absorbing layer 4 is provided between the second electrode 32 and the moisture-barrier layer 5.

The moisture-barrier layer 5 is a layer for preventing penetration of moisture (water vapor) etc. into the organic EL element 3. The moisture-barrier layer 5 is stacked on the concentration gradient layer 6 so as to cover the moisture absorbing layer 4.

The concentration gradient layer 6 functions as a binder layer for integrating the moisture absorbing layer 4 and the moisture-barrier layer 5. The concentration gradient layer 6 may be provided so as to exist in a part of the gap between the moisture absorbing layer 4 and the moisture-barrier layer 5, but preferably, the concentration gradient layer 6 is provided so as to exist in the whole of the gap between the moisture absorbing layer 4 and the moisture-barrier layer 5.

The moisture absorbing layer 4, the concentration gradient layer 6 and the moisture-barrier layer 5 airtightly covers the whole of the organic EL element 3 excepting the terminals 31a and 32a. Specifically, the moisture absorbing layer 4 is airtightly bonded on a surface of the second electrode 32 excepting the terminals 31a and 32a, and airtightly bonded on a peripheral end surface of the organic EL element 3 as illustrated in Fig. 1. The peripheral edge of the moisture absorbing layer 4 is bonded on a surface of the first electrode 31 and a surface of the second electrode 32. The peripheral end surface of the organic EL element 3 is a peripheral surface that forms a thickness of the element 3. Since the moisture-barrier layer 5 is stacked on the outside of the moisture absorbing layer 4, the peripheral end surface of the organic EL element 3 is also covered with the moisture-barrier layer 5. The concentration gradient layer 6 is airtightly bonded on the whole of a surface of the moisture absorbing layer 4, and airtightly bonded on the back surface of the moisture-barrier layer 5.

In the example illustrated in Fig. 1, the moisture absorbing layer 4, the concentration gradient layer 6 and the moisture-barrier layer 5 are provided so as to cover even the peripheral end surface of the organic EL element 3, but the moisture absorbing layer 4 and/or the concentration gradient layer 6 and/or the moisture-barrier layer 5 may be provided so as to cover only a surface of the second electrode 32 without covering the peripheral end surface of the organic EL element 3 (not illustrated).

Any appropriate functional layer may be provided between the support substrate 2 and the organic EL element 3, or between the organic EL element 3 and the moisture absorbing layer 4, or on a surface of the moisture-barrier layer 5 (the functional layer is not illustrated).

### [Support Substrate]

The support substrate is a sheet-shaped material, preferably a flexible sheet-shaped material. The support substrate may be transparent or opaque. However, a transparent support substrate is used when a bottom emission-type organic EL device is formed. Either a transparent support substrate or an opaque support substrate may be used when a top emission-type organic EL device is formed. The transparency means colorless transparency or colored transparency. The index for the transparency may be, for example, a total light transmittance of 70% or more, preferably 80% or more. The total light emittance is measured by a measurement method conforming to JIS K7105 (Testing Methods for Optical Properties of Plastics).

The support substrate to be used in the present invention is a substrate which is excellent in gas barrier properties so that penetration of moisture and oxygen can be prevented. For example, the support substrate may be appropriately selected from a metal sheet, a resin sheet, a glass sheet, a ceramic sheet and the like. In this specification, the "sheet" also includes what is generally called a "film". The metal sheet is not particularly limited, and examples thereof include flexible thin plates composed of stainless steel, copper, titanium, aluminum, alloys and the like. A thickness of the metal sheet is 10 µm to 100 µm, for example. The resin sheet is not particularly limited, and examples include flexible synthetic resin sheets such as those of polyester-based resins such as polyethylene terephthalate (PET), polyethylene naphthalate (PEN), and polybutylene terephthalate (PBT); olefin-based resins having an α-olefin as a monomer component, such as polyethylene (PE), polypropylene (PP), polymethylpentene (PMP), ethylene-propylene copolymers, and ethylene-vinyl acetate copolymers (EVA); polyvinyl chloride (PVC); vinyl acetate-based resins; polycarbonate (PC); polyphenylene sulfide (PPS); amide-based resins such as polyamide (nylon) and wholly aromatic polyamide (aramid); polyimide-based resins; and polyether ether ketone (PEEK). A thickness of the resin sheet is not particularly limited, and is, for example, 10 µm to 200 µm. A known gas barrier layer may be stacked on at least one surface of the resin sheet so that satisfactory gas barrier properties can be imparted.

For preventing a rise in temperature of the organic EL device at the time of driving, the support substrate is preferably excellent in heat dissipation. When a conductive substrate (metal sheet etc.) is used as the support substrate, an insulating layer is provided on a surface of the support substrate for insulating the support substrate against an opposite electrode.

### [Moisture Absorbing Layer]

The moisture absorbing layer is a layer having a quality of absorbing moisture (moisture absorption). The formation material of the moisture absorbing layer is not particularly limited as long as it contains a component having moisture absorption. Hereinafter, the component having moisture absorption is referred to as a "moisture absorbing component". Examples of the moisture absorbing component include boron compounds; sulfides; oxides of alkali metals or alkali earth metals; fluorides, sulfates, halides, phosphates or perchlorates of alkali metals or alkali earth metals.

The moisture absorbing component is at least one of a boron compound and a sulfide, more preferably a boron compound or a sulfide because a moisture absorbing layer can be easily formed using a vacuum vapor deposition method.

The boron compound is a compound containing a boron atom in the molecule thereof, and examples thereof include oxides of boron, oxygen acids of boron, and bromides of boron. Examples of the oxide of boron include boron oxide (B₂O₃). The oxygen acid of boron is an oxygen acid with a boron atom as a central atom, or a salt thereof. Examples of the oxygen acid of boron include orthoboric acid, metaboric acid, hypoboric acid, tetraboric acid, pentaboric acid, and sodium salts, potassium salts, and ammonium salts thereof. Examples of the bromide of boron include boron tribromide (BBr₃). Among them, boron oxide is preferable because it is excellent in moisture absorption. Boron oxide is also excellent in transparency, and therefore suitable as a formation material of a moisture absorbing layer of a top emission-type organic EL device.

Examples of the sulfide include zinc sulfide.

Examples of the alkali metal or alkali earth metal include Li, Na, K, Rb, Cs, Fr, Be, Mg, Ca, Sr, and Ba. Examples of the oxide of an alkali metal or alkali earth metal include sodium oxide, potassium oxide, calcium oxide, barium oxide, and magnesium oxide. Examples of the fluoride of an alkali metal etc. include lithium fluoride, calcium fluoride, magnesium fluoride, and sodium fluoride. Examples of the sulfate of an alkali metal etc. include lithium sulfate, sodium sulfate, and calcium sulfate. Examples of the halide of an alkali metal etc. include calcium chloride, magnesium chloride, and calcium bromide. Examples of the phosphate of an alkali metal etc. include calcium phosphate. Examples of the perchlorate of an alkali metal etc. include barium perchlorate and magnesium perchlorate.

Preferably, the moisture absorbing layer is composed only of a moisture absorbing component, but the moisture absorbing layer may also contain a component that does not have moisture absorption as long as it contains a moisture absorbing component.

Here, in this specification, the phrase "composed only of ...component" means that existence of a very small amount of other components that are inevitably contained is allowed, and existence of a significant amount of other components is excluded.

When the moisture absorbing layer contains a component that does not have moisture absorption, the amount of the component is 10% by volume or less, preferably 5% by volume or less with respect to the moisture absorbing layer.

The thickness of the moisture absorbing layer is not particularly limited, and is, for example, 5 nm to 500 nm, preferably 20 nm to 200 nm, more preferably 30 nm to 200 nm.

### [Moisture-barrier Layer]

The moisture-barrier layer is a layer having a quality (moisture barrier) of preventing penetration of moisture etc. into the organic EL element. The formation material of the moisture-barrier layer is not particularly limited as long as it contains a component having moisture barrier. Hereinafter, the component having moisture barrier is referred to as a "moisture-barrier component". Examples of the moisture-barrier component include compounds containing a metal or a semimetal. The semimetal is a substance having a nature that is somewhere between a metal and a nonmetal. Examples of the metal include the above-mentioned alkali metals and alkali earth metals, and other metals. Examples of metals other than alkali metals and alkali earth metals include titanium, aluminum, zinc, gallium, indium, and magnesium. Examples of the semimetal include silicon, germanium, arsenic, antimony, tellurium, and astatine. It is preferable that the moisture-barrier component contains at least one of carbon and nitrogen because a network structure (reticulated structure) in the moisture-barrier layer can be densely formed, and barrier properties to gases such as water vapor and oxygen can be improved. Further, it is preferable that the moisture-barrier component contains oxygen because a moisture-barrier layer excellent in transparency can be formed.

Accordingly, the moisture-barrier component is more preferably at least one selected from a nitride of a metal or a semimetal, a carbide of a metal or a semimetal, a nitride oxide of a metal or a semimetal, a carbide oxide of a metal or a semimetal, a nitride carbide of a metal or a semimetal, and a nitride carbide oxide of a metal or a semimetal, more preferably at least one selected from a nitride oxide of a metal or a semimetal, a carbide oxide of a metal or a semimetal, a nitride carbide of a metal or a semimetal, and a nitride carbide oxide of a metal or a semimetal. As the moisture-barrier component, for example, at least one selected from a nitride of silicon, a nitride oxide of silicon, a carbide oxide of silicon, a nitride carbide of silicon, and a nitride carbide oxide of silicon can be used. The nitride, nitride oxide, nitride carbide, and nitride carbide oxide of silicon may be silicon nitride, silicon nitride oxide, silicon nitride carbide, and silicon nitride carbide oxide, respectively.

Preferably, the moisture-barrier layer is composed only of a moisture-barrier component, but the moisture-barrier layer may contain other components as long as it contains a moisture-barrier component.

When the moisture-barrier layer contains a component other than a moisture-barrier component, the amount of the component is 10% by volume or less, preferably 5% by volume or less with respect to the moisture-barrier layer.

The thickness of the moisture-barrier layer is not particularly limited, and is, for example, 50 nm to 2000 nm, preferably 100 nm to 1000 nm.

### [Concentration Gradient Layer]

The concentration gradient layer contains a moisture absorbing component and a moisture-barrier component. In the concentration gradient layer, the contents of the moisture absorbing component and the moisture-barrier component are not constant in a thickness direction of the layer, and the contents are changed in the thickness direction. The content refers to a percentage (%) by volume where the volume of the whole concentration gradient layer is set to 100%.

The concentration gradient layer has a portion in which the content of the moisture absorbing component continuously decreases toward the moisture-barrier layer side from the moisture absorbing layer side. In the above-mentioned portion, the content of the moisture-barrier component continuously increases toward the moisture-barrier layer side from the moisture absorbing layer side.

The content of the moisture absorbing component continuously decreases toward the concentration gradient layer from the moisture absorbing layer. On the other hand, the content of the moisture-barrier component continuously decreases toward the concentration gradient layer from the moisture-barrier layer. Accordingly, there is no definite interface either between the moisture absorbing layer and the concentration gradient layer or between the concentration gradient layer and the moisture-barrier layer.

Figs. 2 to 4 are reference graphical views each illustrating a change in contents of a moisture absorbing component and a moisture-barrier component in a moisture absorbing layer, a concentration gradient layer, and a moisture-barrier layer. The concentration gradient layer illustrated in Figs. 2 to 4 has a portion in which the content of the moisture absorbing component gradually decreases toward the moisture-barrier layer side from the moisture absorbing layer side, and the content of the moisture-barrier component gradually increases toward the moisture-barrier layer side from the moisture absorbing layer side.

Specifically, in the concentration gradient layer in a first example illustrated in Fig. 2, the content of the moisture absorbing component gradually linearly decreases toward the moisture-barrier layer side from the moisture absorbing layer side, and the content of the moisture-barrier component gradually linearly increases toward the moisture-barrier layer side from the moisture absorbing layer side.

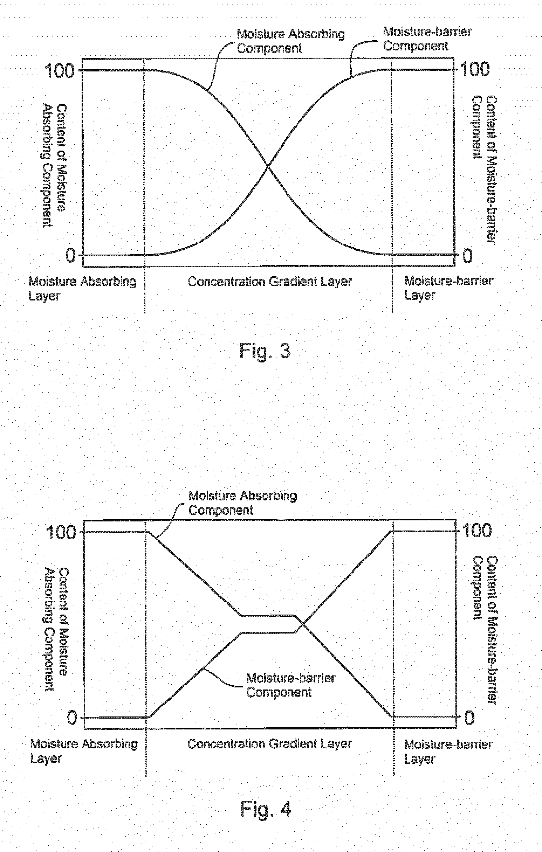

In the concentration gradient layer in a second example illustrated in Fig. 3, the content of the moisture absorbing component gradually curvilinearly decreases toward the moisture-barrier layer side from the moisture absorbing layer side, and the content of the moisture-barrier component gradually curvilinearly increases toward the moisture-barrier layer side from the moisture absorbing layer side. In the concentration gradient layer in each of the examples illustrated in Figs. 2 and 3, the content of the moisture absorbing component continuously decreases and the content of the moisture-barrier component continuously increases toward the moisture-barrier layer side from the moisture absorbing layer side in the overall thickness direction.

In the concentration gradient layer in a third example illustrated in Fig. 4, the content of the moisture absorbing component gradually decreases toward the moisture-barrier layer side from the moisture absorbing layer side, but somewhere on this way, there is a portion in which the content of the moisture absorbing component is constant. In the concentration gradient layer in the third example, the content of the moisture-barrier component gradually increases toward the moisture-barrier layer side from the moisture absorbing layer side, but somewhere on this way, there is a portion in which the content of the moisture-barrier component is constant.

It is practical for the concentration gradient layer of the present invention to have a portion in which the content of the moisture absorbing component gradually decreases and the content of the moisture-barrier component gradually increases toward the moisture-barrier layer side as illustrated in Figs. 2 to 4, and as long as the concentration gradient layer has such a portion, it may have, for example, a portion in which the content of the moisture absorbing component gradually increases and the content of the moisture-barrier component gradually decreases somewhere on the way toward the moisture-barrier layer side.

The moisture absorbing component contained in the concentration gradient layer is of the same kind as the moisture absorbing component forming the moisture absorbing layer, and is preferably identical to the moisture absorbing component forming the moisture absorbing layer. The "same kind" means that the components are compounds that belong to the same category in classification (for example, when the moisture absorbing component forming the moisture absorbing layer is a boron compound, the moisture absorbing component of the concentration gradient layer is also included in the category of boron compounds), and the "being identical" means that the components can be represented by the same chemical formula. The moisture-barrier component contained in the concentration gradient layer is of the same kind as the moisture-barrier component forming the moisture-barrier layer, and is preferably identical to the moisture-barrier component forming the moisture-barrier layer. Similarly to the case of the moisture-absorbing component, the "same kind" means that the components are compounds that belong to the same category in classification, and the "being identical" means that the components can be represented by the same chemical formula.

The moisture absorbing component and the moisture-barrier component in the concentration gradient layer may be chemically bonded, or are not required to be chemically bonded. The "being chemically bonded" means that atoms that form the moisture absorbing component and atoms that form the moisture-barrier component are covalently bonded.

The thickness of the concentration gradient layer is not particularly limited, and is, for example, 5 nm to 1000 nm, preferably 10 nm to 100 nm. When the concentration gradient layer is excessively thin, it may not sufficiently perform a function of hardly separably bonding the moisture absorbing layer and the moisture-barrier layer together, and when the concentration gradient layer is excessively thick, the overall thickness of the organic EL device increases.

### [Organic EL Element Having First Electrode, Organic Layer and Second Electrode]

The first electrode may be either an anode or a cathode. The first electrode is an anode, for example.

The formation material of the first electrode (anode) is not particularly limited, and examples include indium tin oxide (ITO); indium tin oxide including silicon oxide (ITSO); aluminum; gold; platinum; nickel; tungsten; copper; and an alloy. When a bottom emission-type organic EL device is formed, a transparent first electrode is used.

A thickness of the first electrode is not particularly limited, and is usually 10 nm to 1.0 µm, preferably 50 nm to 200 nm.

An organic layer has a laminate structure composed of at least two layers. Examples of a structure of the organic layer include (A) a structure composed of three layers including a positive hole transport layer, a light emitting layer, and an electron transport layer; (B) a structure composed of two layers including a positive hole transport layer and a light emitting layer; and (C) a structure composed of two layers including a light emitting layer and an electron transport layer.

In the organic layer of the above-mentioned (B), the light emitting layer also works as an electron transport layer. In the organic layer of the above-mentioned (C), the light emitting layer also works as a positive hole transport layer.

The organic layer used in the present invention can have any of the structures (A) to (C) mentioned above.

The organic layer having the structure (A) in the case of where the first electrode is an anode is explained below.

The positive hole transport layer is provided on the surface of the first electrode. An arbitrary function layer other than the first electrode and the positive hole transport layer may be interposed between the first electrode and the positive hole transport layer under the conditions in which the light emitting efficiency of the organic EL element is not lowered.

For example, the positive hole injection layer is provided on the surface of the first electrode, and the positive hole transport layer may be provided on the surface of the positive hole injection layer. The positive hole injection layer is a layer having a function of aiding injection of a positive hole from the anode layer to the positive hole transport layer.

The formation material of the positive hole transport layer is not particularly limited as long as it has a positive hole transport function. Examples of the formation material of the positive hole transport layer include an aromatic amine compound such as 4,4',4"-tris(carbazole-9-yl)-triphenylamine (abbreviation: TcTa); a carbazole derivative such as 1,3-bis(N-carbazolyl)benzene; a spiro compound such as N,N'-bis(naphthalene-1-yl)-N,N'-bis(phenyl)benzidine (abbreviation: α-NPD) and N,N'-bis(naphthalane-1-yl)-N,N'-bis(phenyl)-9,9'-spirobifluorene (abbreviation: Spiro-NPB); and a polymer compound. The formation material of the positive hole transport layer may be used alone or in combination of two or more formation materials. Furthermore, the positive hole transport layer may have a multi-layer structure including two or more layers.

A thickness of the positive hole transport layer is not particularly limited, but the thickness of 1 nm to 100 nm is preferable from the viewpoint of reducing drive voltage.

A light emitting layer is provided on the surface of the positive hole transport layer.

A formation material of the light emitting layer is not particularly limited as long as it has light emitting property. Examples of the formation material of the light emitting layer include a low molecular light emission material such as a low molecular fluorescence emission material and a low molecular phosphorescence emission material.

Examples of the low molecular light emission material include an aromatic dimethylidene compound such as 4,4'-bis(2,2'-diphenyl vinyl)-biphenyl (abbreviation: DPVBi); an oxadiazole compound such as 5-methyl-2-[2-[4-(5-methyl-2-benzoxazolyl)phenyl]vinyl]benzoxazole; a triazole derivative such as 3-(4-biphenyl-yl)-4-phenyl-5-t-butyl phenyl-1,2,4-triazole; a styryl benzene compound such as 1,4-bis(2-methyl styryl)benzene; a benzoquinone derivative; a naphthoquinone derivative; an anthraquinone derivative; a fluorenone derivative; an organic metal complex such as an azomethine-zinc complex, tris(8-quinolinolato) aluminum (abbreviation: Alq₃), and the like.

Furthermore, as the formation material of the light emitting layer, a host material doped with light emitting dopant material may be used.

For the host material, for example, the above-mentioned low molecular light emission material can be used, and, other than this, a carbazole derivative such as 1,3,5-tris(carbazo-9-yl)benzene (abbreviation: TCP), 1,3-bis(N-carbazolyl)benzene (abbreviation: mCP), 2,6-bis(N-carbazolyl)pyridine, 9,9-di(4-dicarbazole-benzyl)fluorene (abbreviation: CPF), 4,4'-bis(carbazole-9-yl)-9,9-dimethyl-fluorene (abbreviation: DMFL-CBP), and the like can be used.

Examples of the dopant material include a styryl derivative; a perylene derivative; a phosphorescence emission metal complex including an organic iridium complex such as tris(2-phenyl pyridyl)iridium (III) (Ir(ppy)₃), tris(1-phenyl isoquinoline)iridium (III) (Ir(piq)₃), and bis(1-phenyl isoquinoline) (acetylacetonato) iridium (III) (abbreviation: Ir(piq)₂(acac)), and the like.

Furthermore, the formation material of the light emitting layer may include such as the formation material of the positive hole transport layer mentioned above, the formation material of the electron transport layer mentioned below, and various additives.

A thickness of the light emitting layer is not particularly limited, and is, for example, preferably 2 nm to 100 nm.

The electron transport layer is provided on the surface of the light emitting layer. An arbitrary function layer other than the second electrode and the electron transport layer may be interposed between the second electrode and the electron transport layer under the conditions in which the light emitting efficiency of the organic EL element is not lowered.

For example, the electron injection layer may be provided on the surface of the electron transport layer, and the second electrode may be provided on the surface of the electron injection layer. The electron injection layer is a layer having a function of aiding injection of an electron from the second electrode to the electron transport layer.

A formation material of the electron transport layer is not particularly limited as long as it is a material having an electron transport function. Examples of the formation material of the electron transport layer include a metal complex such as tris(8-quinolinolato) aluminum (abbreviation: Alq₃), bis(2-methyl-8-quinolinolato)(4-phenyl phenolate) aluminum (abbreviation: BAlq); a heteroaromatic compound such as 2,7-bis[2-(2,2'-bipyridine-6-yl)-1,3,4-oxadiazo-5-yl]-9,9-dimethyl fluorene (abbreviation: Bpy-FOXD), 2-(4-biphenylyl)-5-(4-tert-butyl phenyl)-1,3,4-oxadiazole (abbreviation: PBD), 1,3-bis[5-(p-tert-butyl phenyl)-1,3,4-oxadiazole-2-yl]benzene (abbreviation: OXD-7), and 2,2',2"-(1,3,5-phenylene)-tris(1-phenyl-1H-benzimidazole) (abbreviation: TPBi); and a polymer compound such as poly(2,5-pyridine-diyl) (abbreviation: PPy). The formation material of the electron transport layer may be used alone or in combination of two or more types. Furthermore, the electron transport layer may have a multi-layered structure composed of two or more layers.

A thickness of the electron transport layer is not particularly limited, and is preferably 1 nm to 100 nm from the viewpoint of reducing drive voltage.

A second electrode may be either a cathode or an anode. The second electrode is a cathode, for example.

A formation material of the second electrode is not particularly limited, but a transparent second electrode is used when a top emission-type organic EL element is formed. Examples of the formation material of the second electrode which is transparent and has electric conductivity include indium tin oxide (ITO); indium tin oxide including silicon oxide (ITSO); zinc oxide in which electric conductive metal such as aluminum is added (ZnO : Al); and a magnesium-silver alloy, and the like. A thickness of the second electrode is not particularly limited, and is usually 10 nm to 1.0 µm, preferably 50 nm to 200 nm.

### [Use and Effect of Organic EL Device]

The organic EL device of the present invention, alone or in combination of two or more of the organic EL devices, can be used as a light emitting panel of a lighting apparatus or an image display.

The organic EL device of the present invention is provided with a moisture-barrier layer, so that penetration of moisture into the device can be prevented. Further, a moisture absorbing layer is provided between the organic EL element and the moisture-barrier layer, and therefore when a slight amount of moisture passes through the moisture-barrier layer, the moisture absorbing layer absorbs the moisture. Accordingly, penetration of moisture into the organic EL element can be prevented.

Generally, as the moisture absorbing layer absorbs moisture, the moisture absorbing layers is expanded to distort the moisture-barrier layer. As a result, the moisture-barrier layer is partially peeled off from the moisture absorbing layer, or the moisture-barrier layer and the moisture absorbing layer are cracked. Moisture penetrates from the peeled part or cracked part into the organic EL element.

In the organic EL device of the present invention, a concentration gradient layer containing both a moisture absorbing component and a moisture-barrier component is provided between the moisture absorbing layer and the moisture-barrier layer. In the concentration gradient layer, the content of the moisture absorbing component increases as the moisture absorbing layer is approached, and the content of the moisture-barrier component increases as the moisture-barrier layer is approached. The moisture absorbing component in the concentration gradient layer can also absorb moisture. Accordingly, the degree of expansion when the moisture absorbing component in each of the moisture absorbing layer and the concentration gradient layer absorb moisture decreases toward the moisture-barrier layer. As a result, distortion is hard to occur in the moisture-barrier layer, and the moisture absorbing layer and the concentration gradient layer, and the moisture-barrier layer and the concentration gradient layer are hard to be separated from each other. In the present invention, the moisture absorbing layer and the moisture-barrier layer are integrated with each other with the concentration gradient layer interposed therebetween, and therefore occurrence of cracking can be effectively prevented. Accordingly, the organic EL device of the present invention continues to stably emit light over a long period of time.

### [Method for Producing Organic EL Device]

The method for producing an organic EL device according to the present invention includes a moisture absorbing layer forming step of forming a moisture absorbing layer on an organic EL element formed on a support substrate; a concentration gradient layer forming step of forming a concentration gradient layer on the moisture absorbing layer; and a moisture-barrier layer forming step of forming a moisture-barrier layer on the concentration gradient layer.

For the organic EL device of the present invention, a plurality of organic EL devices can be continuously produced by a roll-to-roll method, or organic EL devices can be individually produced.

A method for continuously producing a plurality of organic EL devices by a roll-to-roll method will be described below.

The method for producing an organic EL device by a roll-to-roll method includes a delivery step of delivering a long belt-shaped flexible support substrate; an element forming step of forming a plurality of organic EL elements on the long belt-shaped support substrate; a moisture absorbing layer forming step of forming on each of the organic EL elements a moisture absorbing layer containing a component having moisture absorption; a concentration gradient layer forming step of forming on the moisture absorbing layer a concentration gradient layer which contains a component having moisture absorption and a component having moisture barrier; a moisture-barrier layer forming step of forming on the concentration gradient layer a moisture-barrier layer containing a component having moisture barrier; and a winding step of winding in the form of a roll a belt-shaped laminated body including the belt-shaped support substrate, the organic EL elements, the moisture absorbing layer, the concentration gradient layer and the moisture-barrier layer. In the concentration gradient layer forming step, when the long belt-shaped support substrate after formation of the moisture absorbing layer is conveyed in a vapor deposition area where a first vapor deposition source containing a material that constitutes a component having moisture absorption and a second vapor deposition source containing a material that constitutes a component having moisture barrier are provided side by side in this order, and is conveyed in a direction toward the second vapor deposition source from the first vapor deposition source, a concentration gradient layer can be formed which has a portion in which the content of the component having moisture absorption continuously decreases toward the moisture-barrier layer side from the moisture absorbing layer side.

The moisture absorbing layer forming step, the concentration gradient layer forming step, and the moisture-barrier layer forming step may be sequentially carried out using separate independent vapor deposition apparatuses, or these three steps may be sequentially carried out using one vapor deposition apparatus. It is preferable that the three steps are carried out using one vapor deposition apparatus because a laminate of a moisture absorbing layer, a concentration gradient layer, and a moisture-barrier layer can be easily and conveniently formed.

An apparatus and a method for continuously producing a plurality of organic EL devices by a roll-to-roll method, which are capable of sequentially forming a moisture absorbing layer, a concentration gradient layer, and a moisture-barrier layer, will be described below.

### (Delivery Step)

The delivery step is a step of delivering to a production line a belt-shaped support substrate wound around a roll.

The belt-shaped support substrate is a long and narrow rectangular flexible sheet-shaped material. The length of the long belt-shaped support substrate (length in the long direction) is not particularly limited, and is, for example, 10 m to 1000 m, and the width of the support substrate (length in the short direction) is not particularly limited, and is, for example, 10 mm to 300 mm.

### (Element Forming Step)

The step of forming an organic EL element is carried out in the same manner as before.

To explain it briefly, the delivered support substrate is cleaned in a cleaning bath as necessary, and then dried. After the cleaning and drying step, the first electrode is formed on the surface of the support substrate.

As the formation method of the first electrode, an optimum method can be employed depending on the formation material thereof, and examples of the method include a sputtering method, a vacuum deposition method, and an ink-jet method. In a case where an anode is formed of metal, the vacuum deposition method is used. Furthermore, the support substrate having the first electrode previously patterned may be used. In the case where the support substrate has the previously formed first electrode, it is cleaned and dried after unwound from the roll.

An organic layer is formed on the surface of the first electrode excepting a terminal thereof. An organic layer can be formed by forming a positive hole transport layer, a light emitting layer, and an electron transport layer in this order on the surface of the first electrode, for example. As the formation method of the positive hole transport layer, the light emitting layer, and the electron transport layer, an optimum method can be employed depending on the formation material thereof, and examples of the method include a sputtering method, a vacuum deposition method, an ink-jet method, a coating method, and the like. Those layers are usually formed by the vacuum deposition method.

Subsequently, the second electrode is formed on the surface of the organic layer. The second electrode is formed so as not to cover the terminal of the first electrode. As the formation method of the second electrode, an optimum method can be employed depending on the formation material thereof, and examples of the method include a sputtering method, a vacuum deposition method, an ink-jet method, and the like.

The interval between the organic EL elements is not particularly limited and may be appropriately set. For example, the interval between the organic EL elements is 0.5 mm to 5 mm.

### (Moisture Absorbing Layer Forming Step, Concentration Gradient Layer Forming Step, and Moisture-barrier Layer Forming Step)

These three steps are sequentially carried out. A method for carrying out these steps is such that in a vapor deposition area where a first vapor deposition source containing a material that forms a moisture absorbing component and a second vapor deposition source containing a material that forms a moisture-barrier component are provided side by side in this order, a long belt-shaped support substrate after formation of the organic EL element is conveyed in a direction toward the second vapor deposition source from the first vapor deposition source. The moisture absorbing component is deposited on the support substrate on the first vapor deposition source side, the moisture absorbing component and the moisture-barrier component are mixed and deposited between the first vapor deposition source and the second vapor deposition source, and the moisture-barrier component is deposited on the second vapor deposition source side. Accordingly, on the support substrate after formation of the organic EL elements, a moisture absorbing layer containing a moisture absorbing component, a concentration gradient layer containing a moisture absorbing component and a moisture-barrier component, with the content of the moisture absorbing component continuously decreasing away from the moisture absorbing layer, and a moisture-barrier layer containing a moisture-barrier component can be stacked in this order.

Preferably, the long belt-shaped support substrate after formation of the organic EL elements is conveyed so as to draw a helical trajectory, and the support substrate is made to pass through a vapor deposition area and a non-vapor deposition area alternately.

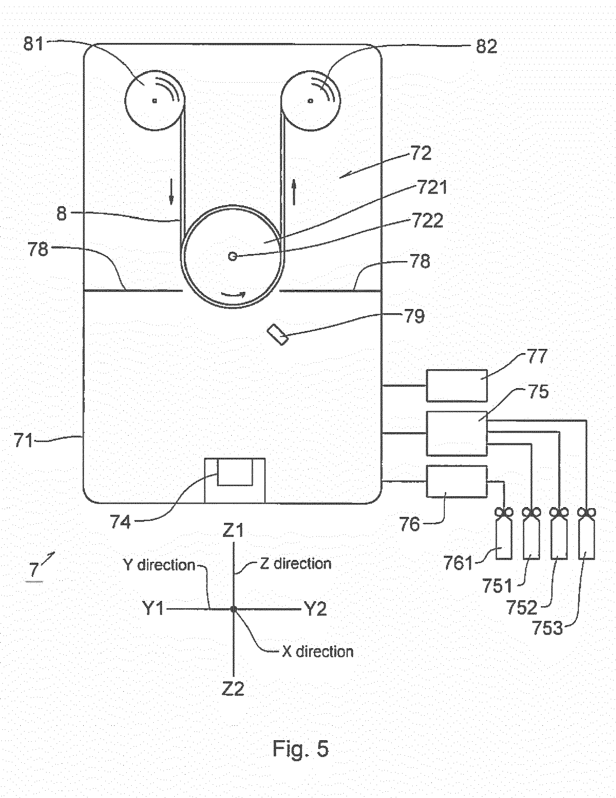

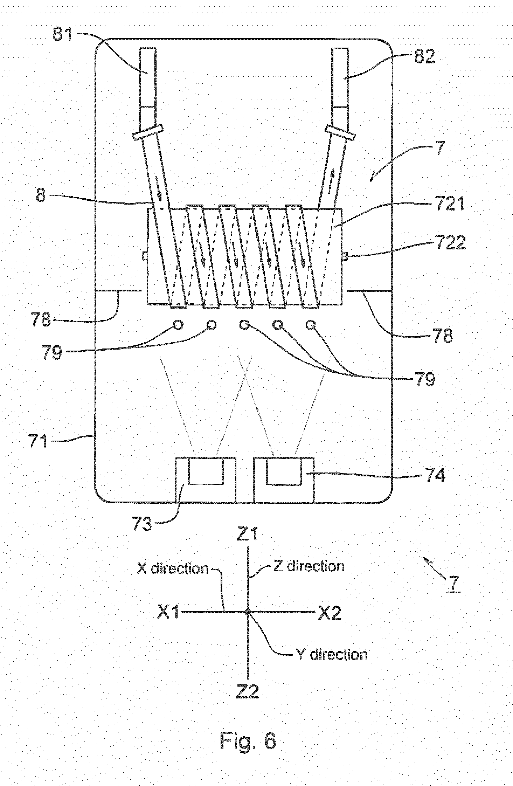

Figs. 5 and 6 each show an example of a configuration of a vapor deposition apparatus that sequentially forms a moisture absorbing layer, a concentration gradient layer, and a moisture-barrier layer. Hereinafter, in each drawing illustrating each vapor deposition apparatus, a direction orthogonally crossing a horizontal plane is referred to as a "Z direction", a direction orthogonally crossing the Z direction is referred to as an "X direction", and a direction orthogonally crossing the Z direction and X direction is referred to as a "Y direction" for the sake of convenience. Further, one side in the X direction is referred to as an "X1 side" and the opposite side in the X direction (side opposite to the one side) is referred to as an "X2 side"; one side in the Y direction is referred to as a "Y1 side" and the opposite side in the Y direction (side opposite to the one side) is referred to as a "Y2 side"; and one side in the Z direction is referred to as a "Z1 side" and the opposite side in the Z direction (side opposite to the one side) is referred to as a "Z2 side".

Fig. 5 is a front view of the vapor deposition apparatus seen from the X2 side in the X direction (direction from X2 to X1), and Fig. 6 is a left side view of the production apparatus seen from the Y1 side in the Y direction (direction from Y1 to Y2).

This vapor deposition apparatus 7 includes a chamber 71, the inside of which can be held in vacuum; a conveyor 72 that continuously sends a long belt-shaped support substrate 8; a plasma source that generates a plasma (not illustrated); a first deposition source 73 and a second deposition source 74 containing a material to be deposited; a reaction gas supply device 75 that supplies a reaction gas into the chamber 71; a discharge gas supply device 76 that supplies a discharge gas into the chamber 71; and a vacuum pump 77 that brings the inside of the chamber 71 into a vacuum state.

The principal part of the conveyor 72 is provided in the chamber 71, and the deposition sources 73 and 74 are provided in the chamber 71.

In the chamber 71, a partition wall 78 that separates the deposition area and the non-deposition area from each other is provided. The deposition area is one region in the chamber 71, at which a material can be deposited on an adherend (i.e. long belt-shaped support substrate 8). The non-deposition area is the other region in the chamber 71, at which a material is not deposited on an adherend. In the illustrated example, with the partition wall 78 as a reference, a region on the Z2 side (lower side) with respect to the partition wall 78 is the deposition area, and a region on the Z1 side (upper side) with respect to the partition wall 78 is the non-deposition area. Of course, it is not necessarily required to provide the partition wall 78, and it is also possible to omit the partition wall 78.

The plasma is not particularly limited, and for example, an arc discharge plasma, a glow discharge plasma, or the like may be used. An arc discharge plasma is preferably used because a very high electron density is achieved unlike a glow discharge plasma. As an arc discharge plasma generation source, for example, a pressure gradient type plasma gun, a direct-current discharge plasma generator, a high-frequency discharge plasma generator, or the like may be used. Among them, a pressure gradient type plasma gun is preferably used because a high-density plasma can be stably generated during deposition.

The first vapor deposition source 73 and the second vapor deposition source 74 are placed side by side on the bottom of the chamber 71 so as to face the conveyor 72. The first vapor deposition source 73 and the second vapor deposition source 74 are placed side by side in a direction along which the support substrate 8 is conveyed. The first vapor deposition source 73 is disposed on the upstream side in the direction along which the support substrate 8 after formation of the organic EL elements is conveyed, and the second vapor deposition source 74 is disposed on the downstream side in the direction along which the support substrate 8 is conveyed.

Materials to be deposited are put on the upper surfaces of the vapor deposition sources 73 and 74.

A material that forms a moisture absorbing component is put in the first vapor deposition source 73, and a material that forms a moisture-barrier component is put in the second vapor deposition source 74.

For example, when the moisture absorbing component is boron oxide, boron oxide is put in the first vapor deposition source 73.

For example, when the moisture-barrier component is at least one selected from a nitride, a carbide, a nitride oxide, a nitride carbide, and a nitride carbide oxide of a metal or a semimetal, a metal or a semimetal, or a nitride, a carbide, a nitride oxide, a nitride carbide, or a nitride carbide oxide thereof is put in the second vapor deposition source 74. When a metal or a semimetal is put in the second vapor deposition source 74, a nitrogen-containing gas, a nitrogen-oxygen-containing gas, a nitrogen-hydrocarbon-containing gas, or a nitrogen-oxygen-hydrocarbon-containing gas is used as a reaction gas. Examples of the nitrogen-containing gas include nitrogen (N₂), ammonia (NH₃), and nitrogen monoxide (NO). Examples of the nitrogen-oxygen-containing gas include nitrogen monoxide (NO), dinitrogen monoxide (N₂O), mixed gases of nitrogen (N₂) and oxygen (O₂). Examples of the nitrogen-hydrocarbon-containing gas include mixed gases of the nitrogen-containing gas and a hydrocarbon-containing gas. Examples of the hydrocarbon-containing gas include methane (CH₄), ethane (C₂H₆), propane (C₃H₈), butane (C₄H₁₀), ethylene (C₂H₄), and acetylene (C₂H₂). Examples of the nitrogen-oxygen-hydrocarbon-containing gas include mixed gases of the nitrogen-containing gas, an oxygen-containing gas and a hydrocarbon-containing gas, and mixed gases of a nitrogen-oxygen-containing gas and a hydrocarbon-containing gas.

Specifically, for example, when the moisture-barrier component is silicon oxide nitride, silicon is put in the second vapor deposition source 74, and a nitrogen-oxygen-containing gas is used as a reaction gas.

As means for vaporizing materials put in the first and second vapor deposition sources 73 and 74, the above-mentioned plasma can be used, but resistance heating or an electron beam may also be used.

The same number of reaction gas storage cylinders 751, 752, and 753 as the number of reaction gases are connected to the reaction gas supply device 75, and the reaction gas supply device 75 supplies a reaction gas at an appropriate pressure into the chamber 71.

Examples of the reaction gas include oxygen-containing gas, nitrogen-containing gas, hydrocarbon-containing gas, and mixture of these gases. Examples of the oxygen-containing gas include oxygen (O₂), dinitrogen monoxide (N₂O), and nitric oxide (NO), examples of nitrogen-containing gas include nitrogen (N₂), anmonia (NH₃), and nitric oxide (NO), and examples of hydrocarbon-containing gas include methane (CH₄), ethane (C₂H₆), propane (C₃H₈), butane (C₄H₁₀), ethylene (C₂H₄), and acethylene (C₂H₂).

A discharge gas storage cylinder 761 is connected to the discharge gas supply device 76, and the discharge gas supply device 76 supplies a discharge gas at an appropriate pressure into the chamber 71. As the discharge gas, typically an inert gas such as an argon gas may be used.

By actuating the vacuum pump 77, the inside of the chamber 71 can be evacuated into a vacuum state.

The conveyor 72 conveys the long belt-shaped support substrate 8 in its long direction by so called a roll-to-roll method.

In this embodiment, the conveyor 72 helically conveys the support substrate 8, and guides the support substrate 8 to the deposition area and the non-deposition area alternately. As such a method for performing helical conveyance, for example, methods disclosed in JP 2009-209438 A and JP 4472962 B can be used.

The conveyor 72 in this embodiment has one guide roller 721 for sending the long belt-shaped support substrate 8 in the long direction while drawing a helical trajectory. The lower part of the guide roller 721 is exposed to the deposition area for guiding the support substrate 8 to the deposition area.

The long belt-shaped support substrate 8 is helically wound around the circumferential surface of the guide roller 721 from the X1 side to the X2 side. Therefore, the support substrate 8 helically wound around the guide roller 721 passes through the deposition area at the lower part of the guide roller 721, and passes through the non-deposition area at the upper part of the guide roller 721.

The guide roller 721 is a cylindrical roller centering on a shaft 722. A direction along which the shaft 722 extends (axis direction) is parallel to the X direction. The guide roller 721 may be configured to be able to rotate about the shaft 722, or may be fixed to the shaft 722. For smoothly sending the support substrate 8, a guide groove or a guide projection (not illustrated) etc. may be formed on the circumferential surface of the guide roller 721.

In the illustrated example, the support substrate 8 is wound around the guide roller 721 so that the support substrate 8 intermittently passes through the deposition area five times while being helically conveyed. In an actual situation, the support substrate 8 is wound around the guide roller 721 so that the support substrate 8 intermittently passes through the deposition area more than five times.

A crystal monitor 79 for measuring and controlling the deposition rate is provided in the vicinity of the support substrate 8 passing through the deposition area. The crystal monitor 79 is provided at five locations at predetermined intervals in correspondence with the number of times the support substrate 8 enters the deposition area.

A temperature controller (not illustrated) may be attached to the guide roller 721 as necessary. The temperature controller is provided for adjusting the surface temperature of the guide roller 721. Examples of the temperature controller include a heat medium circulation device for circulating silicone oil etc.

The long belt-shaped support substrate 8 drawn out from a roll 81 on the upstream side is sent from the Z1 side to the Z2 side, wound around the lower circumferential surface of the guide roller 721, then sent from the Z2 side to the Z1 side, and wound around the upper circumferential surface of the guide roller 721 while being slightly inclined. When the support substrate 8 is passing over the lower circumferential surface of the guide roller 721, the support substrate 8 is sent from the Y1 side to the Y2 side (in Y direction). When the support substrate 8 is passing over the upper circumferential surface of the guide roller 721, the support substrate 8 is sent from the Y2 side to the Y1 side (in Y direction).

Further, the long belt-shaped support substrate 8 is wound around the upper circumferential surface of the guide roller 721, and then similarly sent from the lower circumferential surface to the upper circumferential surface of the guide roller 721 in succession while drawing a helical trajectory. Therefore, the support substrate 8 is sent from the X1 side to the X2 side while drawing a helical trajectory clockwise as a whole as seen from the X1 side, and wound around a roll 82 on the downstream side. Accordingly, the conveyor 72 is configured to send the support substrate 8 while causing the support substrate 8 to pass through the deposition area and the non-deposition area alternately.

Conveyance of the support substrate 8 wound around the guide roller 721 is performed by, for example, unwinding operations of the roll 81 on the upstream side and winding operations of the roll 82 on the downstream side.

A moisture absorbing layer, a concentration gradient layer, and a moisture-barrier layer are sequentially formed using the vapor deposition apparatus 7.

Specifically, the vacuum pump 77 is operated to keep the inside of the chamber 71 in a vacuum state. The pressure in the chamber 71 during vapor deposition is in a range of 0.01 Pa to 100 Pa, preferably 0.02 Pa to 10 Pa.

In the vapor deposition area in the chamber 71, a discharge gas is introduced from the discharge gas supply device 76 while a plasma is generated. The materials put in the first and second vapor deposition sources 73 and 74 are irradiated with, for example, an electron beam to vaporize the materials toward the support substrate 8 after formation of the organic EL elements.

Preferably, an opening/closing shutter (not illustrated) is provided between the vapor deposition sources 73 and 74 and the support substrate 8 beforehand, the shutter is closed until the vapor deposition rate is stabilized after the start of vaporization of the material, and after the vapor deposition rate is stabilized, the shutter is opened to deposit the material on the support substrate 8.

The vapor deposition rate of the material can be appropriately set, and is, for example, 0.1 nm/s to 30 nm/s.

On the other hand, the support substrate 8 after formation of organic EL elements is drawn out from the roll 81 on the upstream side, and introduced into the chamber 71. In the illustrated example, rolls 81 and 82 are disposed on the non-deposition area in the chamber 71, but may be disposed outside the chamber 71.

The length of the long belt-shaped support substrate 8 in the short direction is not particularly limited, and it can be appropriately set, and is, for example, several mm to 1000 mm, preferably several mm to 50 mm.

For example, when a transparent gas barrier film to be used as a support substrate of an organic EL device is produced, the length of the long belt-shaped support substrate 8 in the short direction is set to, for example, several mm to 100 mm, preferably several mm to about 50 mm.

The support substrate 8 is wound around the guide roller 721 of the conveyor 72, and the support substrate 8 is sent so as to draw a helical trajectory, and made to pass through the deposition area and the non-deposition area alternately. The conveyance speed of the support substrate 8 can be appropriately set in consideration of the deposition rate and the thickness of a moisture absorbing layer formed etc., and is, for example, 0.1 to 20 m/minute.

When the support substrate 8 sequentially passes through the deposition area (i.e. when the support substrate 8 passes over the lower part of the guide roller 721), the material is deposited on the support substrate 8.

At the time when the support substrate 8 passes on the first vapor deposition source 73 side, only the moisture absorbing component is deposited to form a moisture absorbing layer.

At the time when the support substrate 8 passes between the first vapor deposition source 73 and the second vapor deposition source 74, a concentration gradient layer having a mixture of the moisture absorbing component and the moisture-barrier component is formed. Specifically, between the first vapor deposition source 73 and the second vapor deposition source 74, the material that forms the moisture absorbing component and the material that forms the moisture-barrier component are vaporized and mixed together in the chamber 71. Here, the amount of the vapor deposition material that forms the moisture absorbing component gradually decreases toward the second vapor deposition source 74 side from the first vapor deposition source 73 side, and on the other hand, the amount of the vapor deposition material that forms the moisture-barrier component gradually increases toward the second vapor deposition source 74 side from the first vapor deposition source 73 side. The support substrate that is helically conveyed passes through the vapor deposition area between the first vapor deposition source 73 and the second vapor deposition source 74 multiple times, so that a concentration gradient can be formed in which the content of the moisture absorbing component gradually decreases toward the moisture-barrier layer side from the moisture absorbing layer side, and the content of the moisture-barrier component gradually increases toward the moisture-barrier layer side from the moisture absorbing layer side.

Then, at the time when the support substrate 8 passes on the second vapor deposition source 74 side, only the moisture-barrier component is deposited to form a moisture absorbing layer on the concentration gradient layer.

In this manner, an organic EL device including a moisture absorbing layer, a concentration gradient layer, and a moisture-barrier layer can be formed.

### (Winding Step)

The winding step is a step of winding around a roll a belt-shaped laminated body (with organic EL elements, a moisture absorbing layer, a concentration gradient layer, and a moisture-barrier layer formed on a belt-shaped support substrate) which is obtained by passing through the above-mentioned steps. In this manner, a long article with a plurality of organic EL devices connected to one another can be obtained by a roll-to-roll method. By appropriately cutting this long article, one or more organic EL devices can be obtained.

Sequential formation of a moisture absorbing layer, a concentration gradient layer, and a moisture-barrier layer using one vapor deposition apparatus 7 has been described above, but the moisture absorbing layer forming step, the concentration gradient layer forming step, and the moisture-barrier layer forming step may be carried out using separate independent vapor deposition apparatuses.

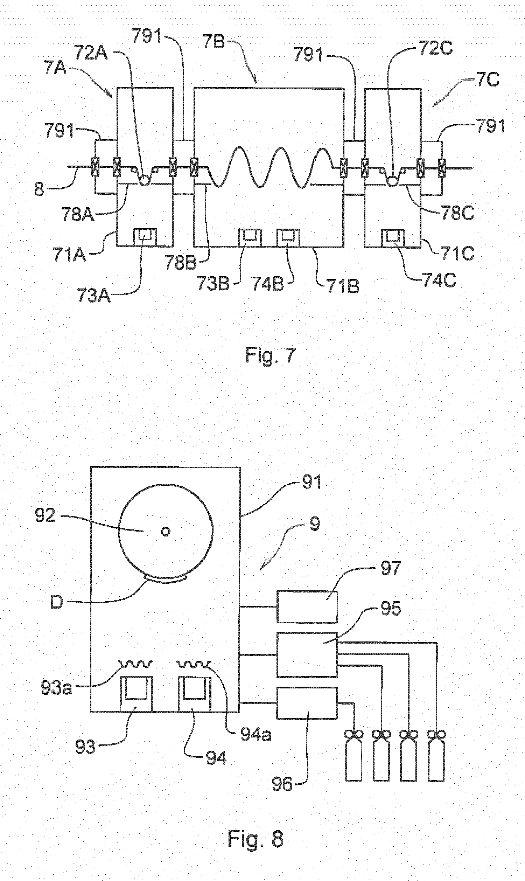

Fig. 7 is a reference view of vapor deposition apparatuses for carrying out the steps independently.

In Fig. 7, a vapor deposition apparatus for forming a moisture absorbing layer 7A, a vapor deposition apparatus for forming a concentration gradient layer 7B, and a vapor deposition apparatus for forming a moisture-barrier layer 7C are provided in this order. The vapor deposition apparatuses 7A, 7B, and 7C include chambers 71A, 71B, and 71C, respectively, and the chambers 71A, 71B, and 71C are connected through a pressure control unit 791.

A vapor deposition source 73A charged with a material that forms a moisture absorbing component is provided in the chamber 71A of the vapor deposition apparatus for forming a moisture absorbing layer 7A. A first vapor deposition source 73B charged with a material that forms a moisture absorbing component and a second vapor deposition source 74B charged with a material that forms a moisture-barrier component are provided in the chamber 71B of the vapor deposition apparatus for forming a concentration gradient layer 7B. A vapor deposition source 74C charged with a material that forms a moisture-barrier component is provided in the chamber 71C of the vapor deposition apparatus for forming a moisture-barrier layer 7C.

The chambers 71A, 71B, and 71C of the vapor deposition apparatuses 7A, 7B, and 7C are divided into a vapor deposition area and a non-vapor deposition area by partition walls 78A, 78B, and 78C, respectively. The vapor deposition apparatus for forming a moisture absorbing layer 7A and the vapor deposition apparatus for forming a moisture-barrier layer 7C are provided, respectively, with conveyors 72A and 72C that convey the support substrate in the long direction. The vapor deposition apparatus for forming a concentration gradient layer 7B is provided with a conveyor (not illustrated) that conveys the support substrate while drawing a helical trajectory similarly to the vapor deposition apparatus 7 in Fig. 6.

In addition, the vapor deposition apparatuses 7A, 7B, and 7C each include a plasma source, a reaction gas supply device, a discharge gas supply device, a vacuum pump and so on similarly to the vapor deposition apparatus 7 described above.

In Fig. 7, the support substrate 8 after formation of the organic EL elements is conveyed into the chamber 71A of the vapor deposition apparatus for forming a moisture absorbing layer 7A, so that a moisture absorbing layer can be formed on the organic EL elements of the support substrate 8. Next, the support substrate 8 after formation of the moisture absorbing layer is conveyed into the chamber 71B of the vapor deposition apparatus for forming a concentration gradient layer 7B, so that on the moisture absorbing layer, a concentration gradient layer can be formed in which the content of the moisture absorbing component gradually decreases toward the moisture-barrier layer side from the moisture absorbing layer side, and the content of the moisture-barrier component gradually increases toward the moisture-barrier layer side from the moisture absorbing layer side. The support substrate 8 after formation of the concentration gradient layer is conveyed into the chamber 71C of the vapor deposition apparatus for forming a moisture-barrier layer 7C, so that a moisture-barrier layer can be formed on the concentration gradient layer.

In this manner, the organic EL device of the present invention can also be produced by using three vapor deposition apparatuses.

In the vapor deposition apparatus for forming a moisture absorbing layer 7A and the vapor deposition apparatus for forming a moisture-barrier layer 7C, the support substrate may be conveyed while a helical trajectory is drawn.

### EXAMPLES

Hereinafter, the present invention is described in detail with reference to following Examples and Comparative Examples. However, the present invention is not limited to the following Examples.

### [Example 1]

### (Formation of Organic EL Element)

On a surface of a long belt-shaped polyethylene terephthalate film (PET film), aluminum was vacuum-deposited in a thickness of 150 nm to form an anode. On the surface of the anode, α-NPD (N,N'-bis(naphthalene-1-yl)-N,N'-bis(phenyl)benzidine) was vacuum-deposited in a thickness of 60 nm to form a positive hole transport layer. On the surface of the positive hole transport layer, Alq₃ (tris(8-quinolinolato)aluminum) was vacuum-deposited in a thickness of 40 nm to form a light emitting layer. On the surface of the light emitting layer, lithium fluoride was vacuum-deposited in a thickness of 1 nm to form an electron injection layer. On the surface of the electron injection layer, ITO (indium tin oxide) was vacuum-deposited in a thickness of 100 nm to form a cathode.

### (Formation of Moisture Absorbing Layer, Concentration Gradient Layer, and Moisture-barrier Layer)

A moisture absorbing layer, a concentration gradient layer, and a moisture-barrier layer are sequentially formed using three vapor deposition apparatuses as illustrated in Fig. 7.

Specifically, a vapor deposition apparatus for forming a moisture absorbing layer as illustrated in Fig. 7 was used to form a moisture absorbing layer in the following manner: the film after formation of the organic EL element was introduced into a chamber, and on the surface of the cathode on the film, B₂O₃ (boron oxide) was vacuum-deposited in a thickness of 80nm (vapor deposition rate: 1 nm/s).

Next, a vapor deposition apparatus for forming a concentration gradient layer as illustrated in Fig. 7 was used to form a concentration gradient layer in the following manner: the film after formation of the moisture absorbing layer was introduced into a chamber, and on the surface of the moisture absorbing layer, B₂O₃ and SiON were co-deposited. In formation of the concentration gradient layer, the film was helically conveyed so as to pass through a vapor deposition area and a non-vapor deposition area alternately five times.

Next, a vapor deposition apparatus for forming a moisture-barrier layer as illustrated in Fig. 7 was used to form a moisture-barrier layer in the following manner: the film after formation of the concentration gradient layer was introduced into a chamber, and on the surface of concentration gradient layer, SiON was vacuum-deposited in a thickness of 300 nm (vapor deposition rate: 1 nm/s).

For vapor deposition of SiON, a pressure gradient-type plasma gun was used as a plasma source, silicon particles were used as a vapor deposition source, and nitrogen (N₂) and oxygen (O₂) were used as reaction gases.

In this manner, a top emission-type organic EL device was prepared.

A composition of the concentration gradient layer in the prepared organic EL device was examined by depth analysis of an X - ray photoelectron spectrum (XPS), and the result showed that the amount of B₂O₃ gradually decreased and the amount of SiON gradually increased away from the moisture absorbing layer. There was no definite interface either between the moisture absorbing layer and the concentration gradient layer or between the concentration gradient layer and the moisture-barrier layer. A thickness of the concentration gradient layer (portion in which B₂O₃ and SiON coexisted) was measured, and the result showed that the thickness was about 60 nm.

### (Configuration of Organic EL Device of Example 1)

Moisture-barrier layer: SiON with a thickness of 300 nm
Concentration gradient layer: thickness: about 60 nm, B₂O₃ and SiON coexist on the gradient
Moisture absorbing layer: B₂O₃ with a thickness of 80 nm
Cathode: ITO with a thickness of 100 nm
Electron injection layer: LiF with a thickness of 1 nm
Light emitting layer: Alq₃ with a thickness of 40 nm
Positive hole transport layer: α-NPD with a thickness of 60 nm
Anode: Al with a thickness of 150 nm
Substrate: PET film

### [Comparative Example 1]

An organic EL device was prepared in the same manner as in Example 1 except that a concentration gradient layer was not formed (i.e. a moisture-barrier layer was formed directly on the surface of a moisture absorbing layer).

### [Comparative Example 2]

On a surface of a commercial sheet-like glass substrate, aluminum was vacuum-deposited in a thickness of 150 nm to form an anode. On the surface of the anode, α-NPD (N,N'-bis(naphthalene-1-yl)-N,N'-bis(phenyl)benzidine) was vacuum-deposited in a thickness of 60 nm to form a positive hole transport layer. On the surface of the positive hole transport layer, Alq₃ (tris(8-quinolinolato)aluminum) was vacuum-deposited in a thickness of 40 nm to form a light emitting layer. On the surface of the light emitting layer, lithium fluoride was vacuum-deposited in a thickness of 1 nm to form an electron injection layer. On the surface of the electron injection layer, ITO (indium tin oxide) was vacuum-deposited in a thickness of 100 nm to form a cathode.

### (Formation of Moisture Absorbing Layer, Mixed Layer, and Moisture-barrier Layer)

Fig. 8 is a schematic reference view of a vapor deposition apparatus used in Comparative Example 2.

The vapor deposition apparatus 9 includes a chamber 91; a drum 92 provided above the chamber 91; a first vapor deposition source 93 and a second vapor deposition source 94 each provided on the bottom of the chamber 91; shutters 93a and 94a corresponding to these vapor deposition sources, respectively; a reaction gas supply device 95 that supplies a reaction gas into the chamber 91; a discharge gas supply device 96 that supplies a discharge gas into the chamber 91; a vacuum pump 97 that brings the inside of the chamber 91 into a vacuum state; and a plasma source (not illustrated). The glass plate D after formation of the organic EL element is mounted on the surface of the drum 92 so as to face the vapor deposition sources 93 and 94.

B₂O₃ (boron oxide) was put in the first vapor deposition source 93, and silicon was put in the second vapor deposition source 94 in the vapor deposition apparatus 9. The vapor deposition apparatus 9 was operated while the shutter 93a was opened and the shutter 94a was closed, so that on the surface of the cathode on the glass plate, B₂O₃ (boron oxide) was vacuum-deposited in a thickness of 20 nm (vapor deposition rate: 1nm/s) to form a moisture absorbing layer.

Next, the vapor deposition apparatus 9 was operated while the shutter 93a and the shutter 94a were opened by a predetermined amount, so that a first mixed layer of B₂O₃ : SiON (silicon oxide nitride) = 7 : 3 (volume ratio) was formed on the surface of the moisture-absorbing layer. The first mixed layer was formed by co-deposition with the vapor deposition rate of B₂O₃ controlled to 0.7 nm/s and the vapor deposition rate of SiON controlled to 0.3 nm/s. The control was adjusted by the opening degree of the shutters 93a and 94a. The thickness of the first mixed layer was 20 nm.

Next, a second mixed layer of B₂O₃ : SiON = 5 : 5 (volume ratio) was formed on the surface of the first mixed layer. The second mixed layer was formed by co-deposition with the vapor deposition rate of B₂O₃ controlled to 0.5 nm/s and the vapor deposition rate of SiON controlled to 0.5 nm/s. The thickness of the second mixed layer was 20 nm.

Further, a third mixed layer of B₂O₃ : SiON = 3 : 7 (volume ratio) was formed on the surface of the second mixed layer. The third mixed layer was formed by co-deposition with the vapor deposition rate of B₂O₃ controlled to 0.3 nm/s and the vapor deposition rate of SiON controlled to 0.7 nm/s. The thickness of the third mixed layer was 20 nm.

Finally, the vapor deposition apparatus 9 was operated while the shutter 93a was closed and the shutter 94a was opened, so that on the surface of the third mixed layer, SiON was vacuum-deposited in a thickness of 300 nm (vapor deposition rate: 1nm/s) to form a moisture-barrier layer.

For vapor deposition of SiON, a pressure gradient-type plasma gun was used as a plasma source, and nitrogen (N₂) and oxygen (O₂) were used as reaction gases.

In this manner, an organic EL device of Comparative Example 2 was prepared.

### (Configuration of Organic EL Device of Comparative Example 2)

Moisture-barrier layer: SiON with a thickness of 300 nm
Third mixed layer: thickness: 20 nm, B₂O₃ : SiON = 3 : 7
Second mixed layer: thickness: 20 nm, B₂O₃ : SiON = 5 : 5
First mixed layer: thickness: 20 nm, B₂O₃ : SiON = 7 : 3
Moisture absorbing layer: B₂O₃ with a thickness of 20 nm
Cathode: ITO with a thickness of 100 nm
Electron injection layer: LiF with a thickness of 1 nm
Light emitting layer: Alq₃ with a thickness of 40 nm
Positive hole transport layer: α-NPD with a thickness of 60 nm
Anode: Al with a thickness of 150 nm
Substrate: glass substrate

### [Comparative Example 3]

An organic EL device was prepared in the same manner as in Comparative Example 2 except that the first mixed layer and the third mixed layer were interchanged with each other.

### (Configuration of Organic EL Device of Comparative Example 3)

Moisture-barrier layer: SiON with a thickness of 300 nm
Third mixed layer: thickness: 20 nm, B₂O₃ : SiON = 7 : 3
Second mixed layer: thickness: 20 nm, B₂O₃ : SiON = 5 : 5
First mixed layer: thickness: 20 nm, B₂O₃ : SiON = 3 : 7
Moisture absorbing layer: B₂O₃ with a thickness of 20 nm
Cathode: ITO with a thickness of 100 nm
Electron injection layer: LiF with a thickness of 1 nm
Light emitting layer: Alq₃ with a thickness of 40 nm
Positive hole transport layer: α-NPD with a thickness of 60 nm
Anode: Al with a thickness of 150 nm
Substrate: glass substrate

### [Comparative Example 4]

An organic EL device was prepared in the same manner as in Comparative Example 2 except that the first mixed layer and the third mixed layer were not formed, and only one mixed layer (B₂O₃ : SiON = 5 : 5) was formed in a thickness of 60 nm between a moisture absorbing layer and a moisture-barrier layer.

### (Configuration of Organic EL Device of Comparative Example 4)

Moisture-barrier layer: SiON with a thickness of 300 nm
Mixed layer: thickness: 60 nm, B₂O₃ : SiON = 5 : 5
Moisture absorbing layer: B₂O₃ with a thickness of 20 nm
Cathode: ITO with a thickness of 100 nm
Electron injection layer: LiF with a thickness of 1 nm
Light emitting layer: Alq₃ with a thickness of 40 nm
Positive hole transport layer: α-NPD with a thickness of 60 nm
Anode: Al with a thickness of 150 nm
Substrate: glass substrate

### [Measurement of Light Emission Life of Organic EL Device]

For each of Examples and Comparative Examples, one organic EL device was arbitrarily selected, incorporated in an experimental circuit, stored at 60°C and 90% RH, and made to emit light over a long period of time by applying a voltage. The brightness at the initial stage of light emission was set to 100%, and time until the brightness decreased to 70% was measured.

The results thereof are shown in Table 1.

**[Table 1]**

| | Time elapsed (h) |
|---|---|
| Example 1 | 500 |
| Comparative Example 1 | 100 |
| Comparative Example 2 | 400 |
| Comparative Example 3 | 150 |
| Comparative Example 4 | 300 |

As is evident from Table 1, the organic EL device of Example 1 emitted light over a relatively long period of time. In Example 1, a concentration gradient layer in which the ratio of the moisture absorbing component and the moisture-barrier component is continuously changed is provided between the moisture absorbing layer and the moisture-barrier layer. In Comparative Example 2, three mixed layers in which the ratio of the moisture absorbing component and the moisture-barrier component is changed stepwise are provided between the moisture absorbing layer and the moisture-barrier layer. From comparison between Example 1 and Comparative Example 2, it is apparent that an organic EL device in which the ratio of the moisture absorbing component and the moisture-barrier component is gradually changed has significantly increased light emission time.

### INDUSTRIAL APPLICABILITY

The organic EL device of the present invention can be used for illuminating devices, image displays, or the like.

1 Organic EL device, 2 Support substrate, 3 Organic EL element, 4 Moisture absorbing layer, 5 Moisture-barrier layer, 6 Concentration gradient layer

## Claims

1. An organic electroluminescence device comprising:
a support substrate; an organic electroluminescence element provided on the support substrate; a moisture absorbing layer provided on the organic electroluminescence element; a moisture-barrier layer provided on the moisture absorbing layer; and a concentration gradient layer provided between the moisture absorbing layer and the moisture-barrier layer, wherein
the moisture absorbing layer contains a component having moisture absorption,
the moisture-barrier layer contains a component having moisture barrier, and
the concentration gradient layer contains a component having moisture absorption and a component having moisture barrier, and has a portion in which the content of the component having moisture absorption continuously decreases toward the moisture-barrier layer side from the moisture absorbing layer side.

2. The organic electroluminescence device according to claim 1, wherein in the portion, the content of the component having moisture barrier continuously increases toward the moisture-barrier layer side from the moisture absorbing layer side.

3. The organic electroluminescence device according to claim 1 or 2, wherein the content of the component having moisture absorption continuously decreases toward the concentration gradient layer from the moisture absorbing layer.

4. The organic electroluminescence device according to any one of claims 1 to 3, wherein the content of the component having moisture barrier continuously decreases toward the concentration gradient layer from the moisture-barrier layer.

5. A method for producing an organic electroluminescence device, the method comprising:
a moisture absorbing layer forming step of forming a moisture absorbing layer, which contains a component having moisture absorption, on a long belt-shaped support substrate provided with an organic electroluminescence element;
a concentration gradient layer forming step of forming on the moisture absorbing layer a concentration gradient layer which contains a component having moisture absorption and a component having moisture barrier; and
a moisture-barrier layer forming step of forming on the concentration gradient layer a moisture-barrier layer containing a component having moisture barrier, wherein
in the concentration gradient layer forming step, the support substrate after formation of the moisture absorbing layer is conveyed in a vapor deposition area where a first vapor deposition source containing a material that constitutes a component having moisture absorption and a second vapor deposition source containing a material that constitutes a component having moisture barrier are provided side by side in this order, and a conveying direction of the support substrate is a direction toward the second vapor deposition source from the first vapor deposition source.

6. The method for producing an organic electroluminescence device according to claim 5, wherein in the concentration gradient layer forming step, the support substrate is conveyed so as to draw a helical trajectory, and is made to pass through the vapor deposition area and a non-vapor deposition area alternately.
